# FASCICULE DE BREVET EUROPEEN

(11) **EP 2 620 987 B1**
(45) Date de publication et mention de la délivrance du brevet: **12.09.2018**
(21) Numéro de dépôt: 12000537.6
(22) Date de dépôt: 27.01.2012
(51) Int. Cl.: H02S 40/44, H01L 31/054, H01L 31/052

(54) **Équipments et systèmes de concentration / récupération de l'énergie solaire et applications industrielles et domestiques**
Geräte und Systeme zur Konzentration/Rückgewinnung von Sonnenenergie, und Anwendungen für die Industrie und Privathaushalte
Devices and systems for concentration / collection of solar energy and industrial and household applications

(43) Date de publication de la demande: 31.07.2013
(73) Titulaire: CS Consulting Sarl, 85330 Noirmoutier-en-l'Île (FR)
(72) Inventeur: Roussac, Arnaud, 21200 Beaune (FR)
(74) Mandataire: Cabinet Plasseraud

(56) Documents cités:
- EP-A1- 2 187 245
- WO-A1-02/080286
- WO-A1-2009/121174
- WO-A1-2010/003115
- DE-C1- 4 405 650
- US-A- 4 361 717
- US-A1- 2008 302 357

## Description

### SECTEUR TECHNIQUE

La présente invention concerne le secteur technique des équipements, dispositifs et systèmes de récupération de l'énergie solaire et plus particulièrement par concentration du rayonnement solaire.

### ART ANTERIEUR

Le monde connaît depuis plus d'un siècle un important développement économique. Le développement industriel, l'augmentation du parc automobile et la multiplication des équipements domestiques ont provoqué une croissance importante de la demande énergétique. Malheureusement, cette croissance de la demande a été majoritairement couverte par l'importation de sources d'énergies fossiles, motivée par des considérations économiques. D'autres facteurs comme les émissions de CO₂, le caractère limité de nos réserves fossiles, et l'indépendance énergétique nationale n'ont pas été pris en compte.

Comme alternative à ces préoccupations, le développement et l'implémentation des énergies renouvelables sont incontournables. Des ressources énergétiques illimitées et abondamment disponibles existent et doivent être exploitées. Certaines, comme l'énergie éolienne ou hydraulique connaissent déjà un développement technique et commercial important et sont économiquement compétitives. D'autres, comme l'énergie solaire et thermoélectrique, sont techniquement disponibles, mais leur compétitivité nécessite une plus grande confiance de la part des entreprises privées et des institutions publiques afin de favoriser l'implémentation de ce type de systèmes et de favoriser une diminution des coûts par les économies d'échelle. Dans l'optique de la production d'électricité, l'énergie solaire est une source d'énergie propre et inépuisable.

Actuellement les technologies de **concentration solaire** sont celles qui présentent le plus de possibilités pour une exploitation commerciale, ces technologies se basent sur des collecteurs qui concentrent la radiation solaire. Les énergies renouvelables possèdent généralement une limitation due à leur caractère intermittent à leur difficulté de stockage. Si la limitation due au stockage est importante pour des énergies comme l'énergie éolienne ou photovoltaïque, elle l'est moins pour la concentration solaire, qui utilise généralement des systèmes de stockage de chaud ou qui peuvent être hybridées avec d'autres sources énergétiques. Les concentrateurs solaires sont une technologie relativement récente, possédant un important potentiel de développement. Ils offrent une opportunité aux pays ensoleillés comparable à celle des fermes éoliennes pour les pays côtiers. Les endroits les plus prometteurs pour l'implantation de ces technologies sont ceux du sud-ouest des Etats-Unis, l'Amérique du Sud, une grande partie de l'Afrique, les pays méditerranéens et du Moyen Orient, les plaines désertiques d'Inde et du Pakistan, la Chine, l'Australie, etc... Dans beaucoup de régions du monde, un kilomètre carré de terrain suffirait à générer jusqu'à 120 GWh d'électricité par an, grâce à la technologie des centrales solaires.

Dans le domaine de la **concentration solaire**, deux technologies coexistent : la concentration par réflexion (utilisant des miroirs) et la concentration par transmission (ayant recours à des lentilles).

### Les capteurs cylindro-paraboliques :

La technologie des capteurs cylindro-paraboliques est actuellement la plus éprouvée des techniques de concentration solaire. De nombreuses installations ont déjà été testées et commercialisées, dont certaines dans les années 80.

L'énergie thermique reçue au collecteur est absorbée par un tuyau métallique à l'intérieur d'un tube en verre sous vide. Le fluide (huile synthétique) qui circule à l'intérieur du tuyau, est chauffé à une température d'environ 400°C. Ce fluide est ensuite pompé à travers des échangeurs conventionnels afin de produire de la vapeur surchauffée qui fait fonctionner une turbine/générateur électrique. Le collecteur est le composant de base du champ solaire. Il est composé d'un réflecteur parabolique (miroir), d'une structure métallique, d'un tube récepteur et du système de poursuite solaire.

Les miroirs sont composés de verre pauvre en fer, dont le coefficient de transmission optique atteint 98%. Ce verre est recouvert d'une pellicule d'argent en sa partie inférieure, et d'un enduit spécial de protection. Un réflecteur de bonne qualité peut réfléchir 97% du rayonnement incident. Le facteur de concentration pour un capteur cylindro-parabolique est d'approximativement 80. De tels capteurs sont par exemple décrits dans le document DE 4405650.

### Les capteurs à Miroirs de Fresnel :

Un facteur de coût important dans la technologie des collecteurs cylindro-paraboliques est dû à la mise à forme du verre. Afin de diminuer ce coût, plusieurs groupes de recherche travaillent sur des prototypes de collecteurs de Fresnel à focalisation linéaire. L'idée est d'approximer la forme parabolique du collecteur par une succession de miroirs plans.

Un premier étage de réflecteurs est installé sur le sol. Le rayonnement est réfléchi au foyer de la parabole approximée par le jeu de miroirs. Un deuxième étage de réflecteurs redirige le rayonnement vers le tube récepteur.

Ce second étage de réflecteurs, en plus de réfléchir le rayonnement, joue aussi le rôle d'isolant pour le tube récepteur. Il est en effet recouvert d'une importante couche d'isolation en sa partie supérieure. La partie inférieure est quant à elle isolée par une vitre.

### Les capteurs paraboliques :

Les capteurs paraboliques fonctionnent d'une manière autonome. Ils suivent le soleil sur deux axes afin de concentrer le rayonnement solaire sur le foyer de la parabole réfléchissante. Le rapport de concentration est souvent supérieur à 1000 avec une température de 750°C. **Les capteurs à point solaire** :
Les capteurs à point solaire fonctionnent en double structure. La première structure (les miroirs) renvoie le rayonnement solaire dans un seul point situé dans la deuxième structure la centrale de réception. Les miroirs suivent le soleil sur deux axes afin de concentrer le rayonnement solaire sur le foyer de la centrale de réception. Le rapport de concentration est souvent supérieur à 2000 avec une température de 1000°C. De tels capteurs sont par exemple décrits dans le document EP 2187245.

### Les capteurs à lentille de Fresnel :

Par rapport à une lentille simple, la lentille de Fresnel réduit la quantité de verre à utiliser en la découpant en un ensemble de sections annulaires concentriques connues sous le nom de *zones de Fresnel.* Pour chacune de ces zones, l'épaisseur est réduite, ce qui fait que la surface globale de la lentille n'est plus lisse mais se compose de plusieurs surfaces de même courbure, séparées par des discontinuités. Bien entendu, cette diminution de l'épaisseur et donc du poids a un prix : celui de la qualité optique, les anneaux étant visibles.

Ces technologies sont déjà aujourd'hui en exploitation mais chacune d'elle comporte des avantages et inconvénients.

Les miroirs présentent les désavantages d'être plus fragiles, d'induire des erreurs de fabrication et en plus d'y être plus sensibles (une erreur entraîne une erreur d'orientation du rayon réfléchi). De plus, l'alignement par rapport au soleil doit être très précis, et enfin il est difficile d'uniformiser le flux atteignant le récepteur, ce qui est désavantageux pour le rendement. Leurs avantages majeurs résident dans le fait d'être insensibles à la longueur d'onde (ils sont dits achromatiques), c'est d'autant plus vrai en comparaison avec les lentilles utilisées en concentration solaire.

La concentration solaire par transmission utilise des lentilles de Fresnel réfractives (cf. phares de voitures et phares marins) qui possèdent de gros problèmes de chromaticité ; seule une certaine gamme de longueurs d'onde atteint le récepteur ce qui entraîne de nombreuses pertes.

### Les capteurs cylindro-paraboliques et paraboliques :

Le capteur cylindro-parabolique présente une bonne concentration focale du fait de la forme du miroir ce qui lui permet de produire une concentration importante et un niveau thermique important.

Bien que le capteur concentrateur cylindro-parabolique soit une des technologies les plus utilisées aujourd'hui, ses désavantages sont nombreux. Le premier vient de la forme du miroir elle-même qui positionne le point focal très proche du miroir créant une zone d'ombre.

L'autre désavantage de cette solution provient de l'empreinte au sol utilisé par ces capteurs qui doivent être espacés de façon importante de manière à éviter toute création de zone d'ombre, ces capteurs sont aussi soumis à de fortes contraintes mécaniques.

Enfin, le dernier problème provient du coût de mise en forme du miroir en forme parabolique.

### Les capteurs point solaire :

Les capteurs « point solaire » présentent une excellente concentration focale du fait de la mobilité de chaque miroir ce qui leur permet de produire une concentration importante et un niveau thermique très important, avec un prix de miroir faible, car ils ont une surface plane.

Le système présente deux désavantages majeurs, la complexité du système de « tracking » de chaque miroir et la taille importante des installations.

### Les capteurs à lentille de Fresnel :

Très bonne concentration optique sur les petites surfaces (cf. technologie aujourd'hui développée dans les cellules photovoltaïques multifonctions).

Les problèmes majeurs rencontrés par cette technique sont le coût de fabrication de la lentille, bien que plus faible qu'un miroir parabolique, il est plus important qu'un miroir plan. Mais le problème le plus important provient de ses chromaticités, limitant la transmission du flux énergétique solaire.

### Les capteurs à Miroirs de Fresnel :

Les principaux avantages de cette technologie par rapport aux concentrateurs traditionnels sont : un coût inférieur des miroirs, une meilleure occupation du sol et des contraintes mécaniques dues à la poussée du vent réduites.

Le premier inconvénient de ce système est la performance thermique des collecteurs de Fresnel qui est inférieure de 30% par rapport aux systèmes paraboliques. Cette perte de rendement est due à la surface plane du miroir qui renvoie un spectre lumineux identique.

La concentration solaire directe de ce système est égale au maximum à la taille d'un miroir. Afin d'augmenter la concentration du flux solaire dans cette technologie, on utilise un deuxième miroir concentrateur situé sur le collecteur thermique.

Il est important de constater que de nombreux problèmes techniques doivent encore être résolus avant d'arriver au concentrateur parfait.

### PROBLEME TECHNIQUE

Il existe donc un besoin constant d'amélioration des systèmes existants.

Cependant, le mérite de l'invention est de ne pas se contenter d'une amélioration « à la marge » du rendement énergétique et autres propriétés requises mais d'avoir visé la réalisation d'un saut quantique en termes de plusieurs propriétés.

Un premier problème technique a été de sélectionner la base technique de départ parmi celles qui viennent d'être citées, c'est-à-dire de partir de la base technique qui a semblé être la plus prometteuse, même si elle présentait le plus grand nombre de problèmes techniques à résoudre.

La base technique choisie a été la technologie « à point solaire ». Un des mérites de l'invention est que cette technologie n'était pas celle qui, a priori, offrait les perspectives de développement les plus visibles. En d'autres termes, les « chances de succès » étaient faibles, mais le Demandeur a précisément cherché délibérément le challenge le plus difficile.

Il sera expliqué ci-dessous que, partant de la technologie connue employant des miroirs de concentration du rayonnement solaire, le Demandeur s'est posé, ou a dû faire face, aux problèmes techniques suivants. On verra également que, en fait, il y avait effectivement peu à améliorer dans un système à point solaire, comme on pouvait le craindre, mais, dans ses efforts, le Demandeur en est venu à changer de ligne de recherche et a mis surtout au point un collecteur totalement surprenant.

Les problèmes techniques à résoudre dans ce cadre sont très nombreux et sont notamment les suivants :
- Réduction de la surface au sol des miroirs afin de réduire l'impact du foncier à puissance égale,
- Amélioration de la concentration solaire de manière à obtenir un flux précis et optimal au niveau du récepteur,
- Réduire l'effort mécanique de la structure par rapport aux conditions extérieures (pluie, vent, etc...),
- Élimination des zones d'ombrage sur les concentrateurs,
- Réduction du coût de fabrication des miroirs concaves,
- Contrôle du focal solaire,
- Réduction du coût de transformation du flux solaire en énergie exploitable,
- Réduction des coûts d'entretien,
- le tout en réalisant, non pas une « n ième » amélioration « à la marge » mais un véritable saut quantique de propriétés.

Les principaux problèmes rencontrés ont consisté à permettre une considérable augmentation de la concentration du flux de lumière tout en restant dans un format de miroir le plus plat possible afin de réduire les coûts de fabrication de ce dernier et réduire l'empreinte au sol du capteur. Une autre difficulté a été de constater que même cette amélioration ne répondait pas aux objectifs visés. Le capteur ou collecteur (C) classique était de trop faible rendement. Il a alors fallu repenser totalement le capteur ou collecteur solaire (C) lui même, et la solution a été trouvée lorsque l'idée d'une synergie possible a elle-même été trouvée, c'est-à-dire de permettre et réaliser une synergie entre un capteur solaire « thermique » et un capteur solaire « électrique » produisant de l'énergie électrique et une forte énergie thermique en synergie.

### SOLUTION TECHNIQUE

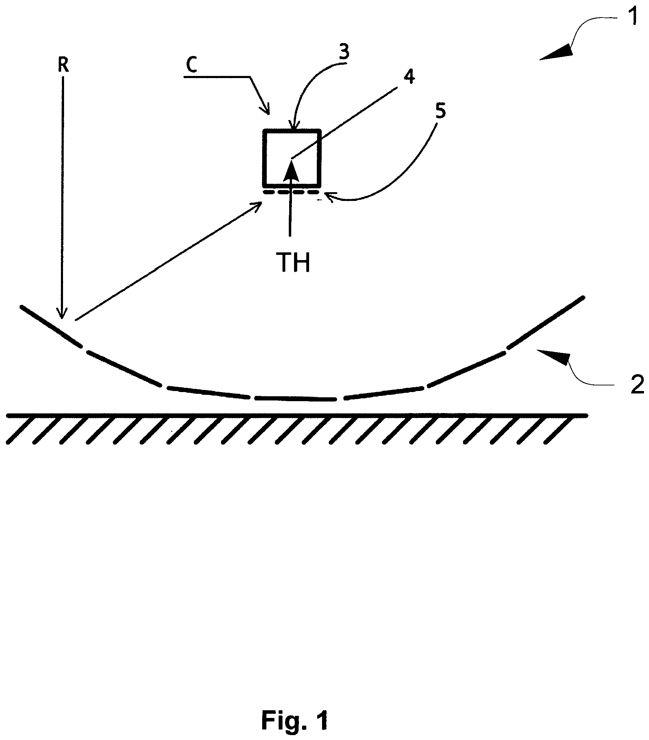

La solution générale retenue selon la présente invention emploie un **capteur solaire** du type général dénommé « à point solaire » (« ou point focus ») selon la revendication 1 et considérablement amélioré par l'emploi de miroirs non plats (et en particulier concaves, à concavité orientée pour une focalisation du rayonnement thermique vers le « collecteur solaire ») qui focalisent le rayonnement solaire vers un « collecteur solaire » (C) complexe (ci-après « **collecteur** » par simplicité) car comprenant essentiellement un « **collecteur thermique** » (3) où circule un fluide caloporteur (4), **figure 1****,** en combinaison synergique avec un « **collecteur électrique** » (5) constitué par au moins un panneau photovoltaïque dont l'échauffement dû à l'exposition solaire est dissipée vers le collecteur thermique (en général, un tube ou un volume de section carrée, rectangulaire ou autre) ; la surface active (recevant le rayonnement solaire R) du « collecteur électrique » est située au point focal de la concentration.

Par « panneaux photovoltaïques », nous désignons ici au moins une cellule photovoltaïque disposée sur un support. De manière préférée, les panneaux photovoltaïques sont composés d'un certain nombre de cellules photovoltaïques, de préférence entre 20 et 300 cellules dites à « multicouches » (voir ci-après) ou entre 1 et 10 cellules photovoltaïques « classiques », le tout pour les dimensions exemplifiées non limitativement ci-après.

Le système peut fonctionner avec des miroirs plats classiques pour « point focus », mais un élément très important de la solution provient du taux de concentration, et il a été trouvé qu'il était très important de concentrer le rayonnement sur deux axes et non un, comme le ferait entre autres un concentrateur classique comme Fresnel à miroir plat. Le fait de travailler en deux axes permet de multiplier la concentration. La concentration deux axes qui sera décrite ci-après comme mode préféré ne peut pas fonctionner avec des miroir plats.

Un mode de réalisation à miroirs plats est donc possible en théorie mais ne représenterait qu'une amélioration du taux de concentration des systèmes existants « à la marge » qui est précisément ce que veut éviter l'invention, qui vise un saut quantique.

Dans ce mode de réalisation, lesdits petits miroirs plats sont arrangés de manière adjacente pour former une forme non plane généralement parabolique et généralement concave orientée vers le collecteur (C).

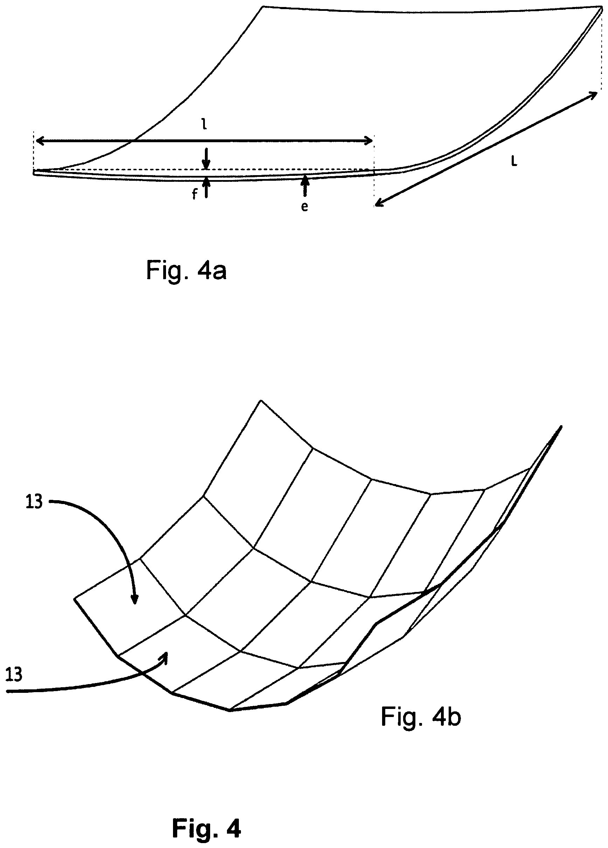

On privilégie donc totalement l'emploi de miroirs non plats (figure 4a).

On trouvera sur la Figure 4b annexée un exemple non limitatif où l'on peut employer un ensemble de petits miroirs plats adoptant une géométrie 3D spéciale formant une surface globale non plane.

### DESCRIPTION DE L'INVENTION

Sous sa forme de moyen général, représentée schématiquement sur la **Figure** 1 annexée, la présente invention repose sur un capteur solaire (1), comportant un équipement de concentration / récupération de l'énergie solaire (« collecteur solaire » ou par simplicité « **collecteur** ») (C), et qui combine :
- un premier moyen (2) de concentration solaire du type **ensemble de miroirs, dit à** « **point solaire** »,
- lequel concentre le rayonnement solaire (R) sur un « collecteur » (C) comportant un moyen récupérateur de l'énergie thermique ou **collecteur thermique** (3) (en général, un tube ou un corps creux de section droite carrée ou rectangulaire) dans lequel circule un fluide caloporteur (4),
- lequel est lui même combiné à un moyen (5) de récupération de l'énergie solaire sous forme d'énergie électrique ou « **collecteur électrique** » (de manière totalement préférée, un ou des panneaux photovoltaïques),
- ledit collecteur électrique (5) et ledit collecteur thermique (3) étant adaptés (en formant le « collecteur ») de telle sorte que ledit collecteur électrique soit exposé au rayonnement solaire et que la chaleur (TH) d'origine solaire et augmentée très fortement par échauffement « intrinsèque » du matériau photovoltaïque dans le collecteur électrique (5) soit dissipée au maximum (flèches TH --→) dans le collecteur thermique (3), le collecteur électrique (5) contribuant ainsi avec une forte synergie au chauffage du fluide caloporteur (4) circulant dans le collecteur thermique.

Ceci est schématisé sur la **figure 1****.**

La présente invention couvre principalement :
- le collecteur (C) complexe combinant un collecteur thermique (3), de préférence isolé thermiquement, en synergie avec un collecteur électrique (5) (panneau(x) photovoltaïque(s)) disposé sur la surface INFERIEURE du collecteur thermique (3) et exposé par le DESSOUS à un rayonnement solaire focalisé/concentré (R), et qui transmet son énergie thermique (TH) vers le collecteur thermique (3) et son fluide caloporteur (4).
ainsi que :
- la combinaison de ce collecteur (C) spécifique avec un système de concentration/focalisation de l'énergie solaire (R) vers le DESSOUS du collecteur photovoltaïque (5),
- ce système étant de préférence un système de type « point focus » à miroirs légèrement courbés, de préférence à double focalisation, ou encore un autre système réfléchissant (le collecteur (C) pouvant produire un excellent rendement grâce à sa structure spécifique et inventive, même si le système réfléchissant l'énergie solaire (R) est moins ou peu performant),
- l'utilisation de miroirs légèrement courbés, de préférence à double focalisation, pour concentrer le rayonnement solaire vers le collecteur (C).

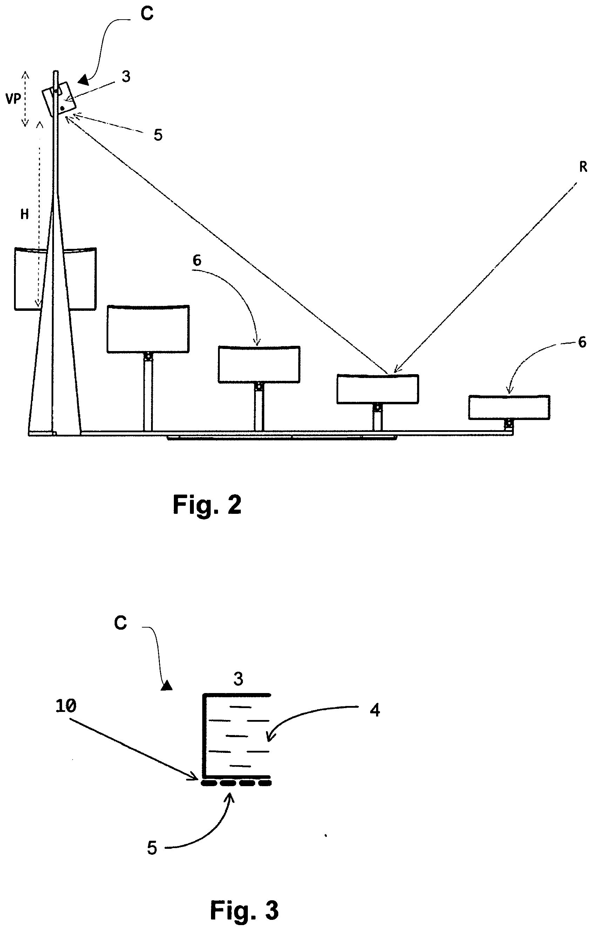

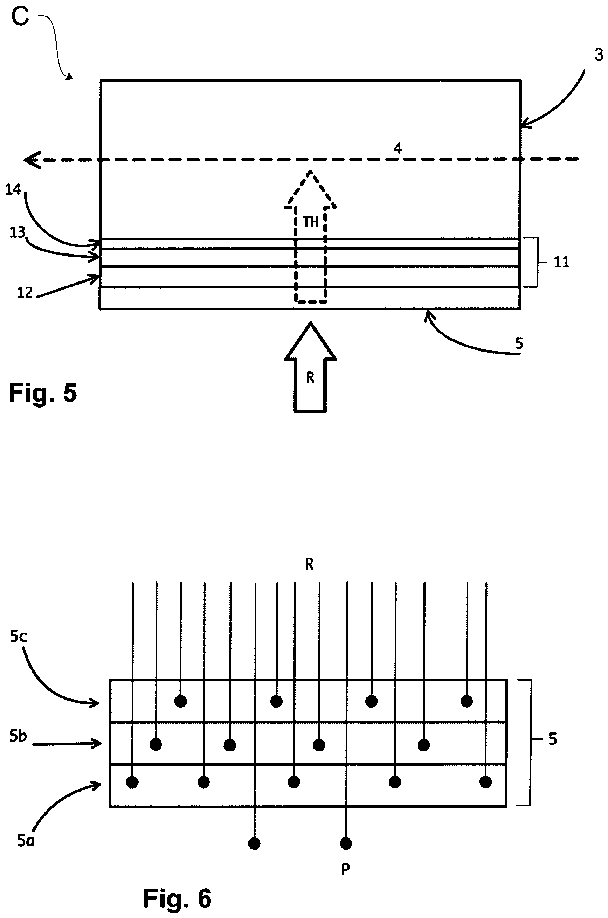

Le mode de réalisation particulièrement préféré, qui est à ce jour le meilleur mode de réalisation, a fait l'objet d'un prototype (représenté entre autres sur la Figure 2 et/ou 3 et surtout sur la Figure 5) qui combine un équipement de concentration du type général dit « à point solaire » qui emploie un nombre adapté de miroirs (6) légèrement courbés focalisant le rayonnement solaire (R) vers le **collecteur** (C) combinant un récupérateur d'énergie thermique (3) (collecteur thermique) dans lequel circule un fluide caloporteur (4) (non référencé sur la figure 2), avec au moins un panneau photovoltaïque (5) (collecteur électrique) disposé sous ledit collecteur thermique (3), ledit panneau (5) et ledit collecteur thermique (3) étant mécaniquement et physiquement liés l'un à l'autre notamment par la liaison physique (10) (11) (détail sur la **Figure 3** et la **figure 5**) pour permettre la dissipation, par un ensemble élaboré de contact physique, de choix des matériaux de liaison, et de liaison mécanique, de la chaleur (TH) emmagasinée dans les panneaux (du fait du rayonnement solaire (R), et également, dans le mode préféré, de leur échauffement « intrinsèque ») vers le collecteur thermique (3) (cf. **figure 5**).

L'homme de métier aura compris que le collecteur thermique et le/les panneaux doivent être constitués au maximum (et au moins au niveau de la liaison mécanique tube/panneaux) en matériaux présentant une forte conductivité thermique, afin d'obtenir une synergie maximale.

De même on choisira de manière tout-à-fait préférée des panneaux photovoltaïques dont la structure va être capable de subir un échauffement très important sous l'effet du rayonnement solaire.

Le ou les panneaux photovoltaïques sont, comme on le verra, placés de manière absolument préférée sous le collecteur thermique et exposés par le dessous (le collecteur thermique étant situé au dessus du panneau) au rayonnement solaire réfléchi (R) (figure 5).

L'homme de métier aura compris que le rayonnement solaire direct sur le dessus du collecteur thermique et/ou sur les panneaux photovoltaïques a un effet énergétique négligeable. A tel point que le collecteur thermique est fortement isolé thermiquement, y compris sur sa surface exposée au rayonnement direct, car les pertes par convection de l'air autour du collecteur seraient plus importantes que l'apport thermique « direct ». Seul compte le rayonnement très intense réfléchi et focalisé par les miroirs, c'est-à-dire le rayonnement réfléchi (R) et frappant le collecteur (C) par le DESSOUS.

L'ensemble formé par le collecteur thermique (tube) ou autre corps creux (récupérateur (3)) et le/les panneaux solaires photovoltaïques (5) (ensemble le « collecteur » (C)) est de préférence mobile selon un axe vertical (cf. sur la Figure 2 les flèches de variation de position (VP)) avec une hauteur moyenne H de position au dessus du miroir supérieur de l'ordre de 2 m, afin d'optimiser la concentration selon la hauteur et la position du soleil (exemple non limitatif).

Comme on le verra sur d'autres modes de réalisation, le « collecteur » (C) peut être mobile sur un support non vertical, et indépendamment les miroirs (6) peuvent être étagés et disposés de différentes façons en fonction de la géométrie du sol, de la latitude et d'autres facteurs évidents, la seule contrainte étant une focalisation sur le collecteur sans effet d'ombrage.

Pour la même raison, l'ensemble du capteur solaire (1) est de préférence mobile en rotation sur 360° qui en pratique sera limité à un secteur de environ 300° selon une orientation générale est - ouest afin de suivre l'azimut du soleil, en fonction de la saison et des heures de la journée, données évidemment connues pour chaque point géographique.

Également pour la même raison, les miroirs peuvent être orientables individuellement par un système à rotule ou analogue.

Les miroirs solaires tout à fait préférés sont de type légèrement courbé selon un mode concave, dans la limite d'élasticité connue du verre, comme représenté en perspective sur la **figure 4a** qui montre un exemple non limitatif de miroir de vue de dessus rectangulaire.

L'exemple particulier et non limitatif employé pour le prototype présente cette forme rectangulaire, avec une **largeur I** de 941 mm, une **longueur L** de 2500 mm et une **flèche f** de 15,5 mm.

La flèche **f** est de l'ordre de 1/30 à 1/150 ème de la plus petite dimension du miroir.

Selon l'invention, **L** sera compris en pratique entre 100 et 10 000 mm, I entre 10 et 2500 mm et **f** entre 0,5 et 100 mm.

L'épaisseur **e** de la plaque de verre sera comprise entre 0,1 et 10 mm ; pour le prototype, elle est de 2 mm.

La forme rectangulaire est la plus efficace industriellement, cependant l'homme de métier saura envisager des formes comparables sans la moindre difficulté.

On peut envisager mais au prix d'un coût de montage et maintenance supérieurs, d'employer pour chaque miroir une série de petits miroirs plats (13) **(****figure 4b****)** accolés dans le sens de la « longueur » définie sur la figure 4a par « L », l'ensemble se rapprochant d'un miroir non plat selon la **Figure 4a** mais avec un rendement moindre.

La nature du collecteur thermique (3) sera le plus proche possible d'un corps noir afin d'absorber le plus possible de rayonnement infrarouge.

Dans ce but, le collecteur thermique sera de préférence en acier inoxydable de qualité 316 L ou encore en cuivre.

L'homme de métier saura imaginer d'autres matériaux se rapprochant plus ou moins d'un corps noir.

Le collecteur thermique (3) est un corps creux de section qui peut en théorie être quelconque mais qui sera de préférence un tube allongé de section transversale rectangulaire ou carrée, ces deux formes de section permettant la meilleure synergie avec le collecteur électrique (notamment par un meilleur contact plat (10, 11)).

Comme nous l'avons vu, les panneaux photovoltaïques seront composés de cellules photovoltaïques.

Les cellules photovoltaïques peuvent être quelconques par exemple du type monocristallin ou polycristallin, mais il a été privilégié pour le prototype des cellules de type multicouches qui présentent le double avantage d'un rendement très élevé et d'un échauffement intrinsèque également élevé.

Par « échauffement intrinsèque » on désigne ici l'échauffement produit dans le panneau en général indépendamment de l'apport solaire ; c'est cet échauffement intrinsèque qui va contribuer très fortement, avec l'échauffement dû à l'exposition directe au rayonnement réfléchi, à l'apport d'énergie thermique (TH) vers le collecteur thermique. On peut aussi désigner ainsi l'ensemble de l'échauffement interne inhérent au panneau (réaction au niveau des cellules) et de l'effet de l'exposition au rayonnement focalisé (R).

On verra ci-dessous que la synergie réalisée permet un réel « saut quantique » de propriétés et notamment de rendement énergétique.

Enfin, on peut considérer une seconde synergie qui est le fait que l'énergie électrique produite par le/les panneaux photovoltaïques améliore encore le bilan énergétique, et peut même permettre, dans certains cas, comme notamment une unité frigorifique, d'alimenter les systèmes internes de fonctionnement d'un générateur de frigories et, par conséquent, de réduire les besoins en alimentation électrique d'origine extérieure jusqu'à éventuellement rendre l'unité électriquement autonome, ce qui représente un facteur important dans de très nombreux pays.

L'homme de métier saura facilement envisager d'autres applications de ce type.

### DESCRIPTION DETAILLEE DE L'INVENTION

Cette description détaillée sera celle du prototype qui est très représentatif de l'état actuel du développement.

Le prototype a été conçu initialement pour répondre à un besoin particulier, de grande importance économique, dans les pays en question, ici une unité frigorifique permettant de congeler des aliments et notamment des produits de la mer.

L'un des problèmes techniques a été de permettre la congélation de 9 t de poisson en 12 h ce qui représente une exigence classique de la profession.

Un autre problème technique a été de rechercher à atteindre la température de congélation à la norme « japonaise », soit congélation à -55°C puis conservation à -40°C, cette norme assurant par l'intensité du choc thermique une conservation bien meilleure du poisson qui conserve ses propriétés organoleptiques et son aspect « frais ».

Il est évident que l'invention permet également de satisfaire d'autres normes un peu moins sévères, par exemple la norme européenne (congélation à -30°C conservation à -18°C).

L'invention permet encore, a fortiori, de répondre aux normes de congélation/conservation soit domestiques soit de collectivités locales et naturellement aussi de leur simple climatisation (logements individuels, bureaux, infirmeries ou dortoirs sur des chantiers, etc...).

Il sera évident que l'invention, au lieu d'alimenter en énergie thermique et éventuellement électrique un générateur de frigories, peut produire directement de l'énergie électrique notamment selon le mode habituel de génération de vapeur d'eau alimentant une turbine. Le fluide caloporteur peut également servir directement au chauffage de locaux, d'intérêt moins évident dans les pays chauds, ou alimenter directement un système industriel en énergie thermique (le générateur de frigories entre dans cette catégorie d'applications).

En fait, pour l'homme de métier, un capteur solaire se résume à une accumulation de pertes d'énergie qui réduisent naturellement très fortement le rendement.

Le problème technique objectif général a donc été de minimiser ces pertes et l'invention y est parvenue de manière élégante et avec des résultats spectaculaires.

On a représenté sur la **Figure 5** annexée le mode préféré de réalisation actuel du **collecteur (C)** en coupe longitudinale verticale.

Les miroirs n'ont pas été représentés car ils ont été décrits de manière générale sur la **Figure 1****.** Ils sont situés sous le « collecteur » (C) (dans le sens vertical) et réfléchissent le rayonnement solaire en le focalisant sur (de manière tout à fait préférée) toute la face inférieure (5) du collecteur (C), cette face inférieure (5) étant en fait le collecteur électrique, typiquement la face réceptrice des cellules photovoltaïques du panneau (5).

Par « face réceptrice » on désigne évidemment la face du panneau qui est destinée par le fabricant à recevoir l'énergie solaire.

La focalisation du rayonnement solaire a été schématiquement représentée par la flèche **(R)** mais il est bien évident que la focalisation est calculée pour que le rayonnement frappe **toute** la surface ou face « réceptrice » (5). Ou sa grande majorité. Réduire l'impact du rayonnement solaire à, par exemple, 80 à 90% n'est pas impossible mais serait nuisible, bien évidemment, au rendement. Ce serait une « perte » injustifiée. Il faut donc viser 95 - 100% de la surface (5) réceptrice, de préférence 100% en évitant tout « ombrage », c'est-à-dire « totalité ou quasi-totalité » de ladite surface.

Selon ce mode de réalisation particulièrement préféré, le « collecteur » **(C)** se compose de :
- au moins un panneau photovoltaïque (collecteur électrique) (5) formant la face inférieure « réceptrice » exposée en totalité ou quasi totalité au rayonnement (R) réfléchi et focalisé par les miroirs (2, 6) non représentés ;
- un ensemble de connexion et de transmission thermique (11) lui-même composé de :
   - un connecteur électrique (12) pour le panneau photovoltaïque, à forte conductivité électrique (cuivre, or) autorisant la transmission de l'énergie thermique,
   - un substrat non conducteur de l'électricité (13) mais autorisant la transmission de l'énergie thermique (céramique),
   - une plaque thermique (14) conductrice de l'énergie thermique et dont le rôle est d'assurer un contact parfait avec la surface inférieure du « collecteur thermique »,
- un « collecteur thermique » (3) dans lequel circule un fluide caloporteur (4). Eau, huile, fluide spécial connu, etc...
- A noter que la couche (14) ou plaque thermique n'est présente que si la face inférieure du collecteur ne la forme pas elle même, et dans ce cas la couche (14) est réduite à une épaisseur appropriée de colle réalisant l'adhérence entre le « photovoltaïque » et le « thermique ».

Les cellules photovoltaïques sont de très faible épaisseur, inférieure à 20, de préférence à 10 microns, et le panneau (5) requière donc en général un support mécanique. Les éléments (11) assurent ce support.

Surtout, outre le fait de générer du courant électrique, le panneau subit un échauffement (« intrinsèque » par réaction dans les cellules (**figure 6**) et « direct ») extrêmement important (la température pouvant atteindre 500°C) qu'il est évidemment essentiel de dissiper.

On utilisera de manière tout à fait préférée une cellule dite « multicouches » du type schématisé en coupe sur la **Figure 6** annexée. Sur cet exemple non limitatif, elle se compose de trois microcouches photovoltaïques (5a, 5b, 5c) superposées. Le grand intérêt est que le rayonnement solaire (R) a trois couches à activer et qu'il y a donc très peu de chances pour qu'il parvienne à traverser les trois couches sans être « intercepté ». Les pertes (P) (souci constant du Demandeur) de rayonnement sont donc très faibles.

Ce type de cellule présente également l'avantage **décisif,** outre une importante production d'énergie électrique d'appoint, sous la focalisation du rayonnement solaire **(R),** d'être porté à une très haute température par exposition « directe » à l'énergie solaire focalisé (R) ET par les réactions « intrinsèques » se produisant dans les cellules de manière connue, ce qui permet de transmettre une énergie thermique **(TH)** très importante vers le collecteur thermique (3).

L'invention réalise donc une synergie entre la production d'énergie électrique et un « dopage » de l'énergie (TH) transmise au collecteur thermique (3), bien supérieure à ce que le collecteur thermique (3) recevrait par simple exposition directe au rayonnement (R), c'est-à-dire sans les couches (5) et (11).

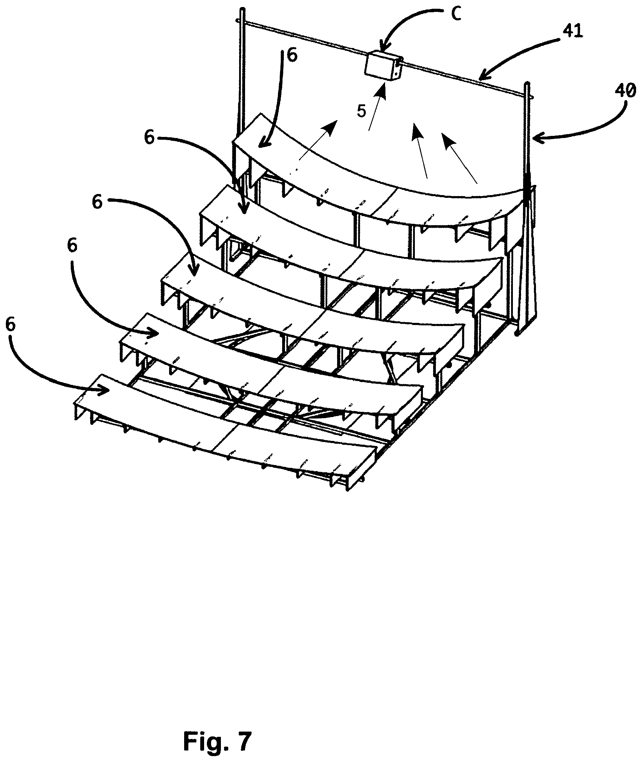

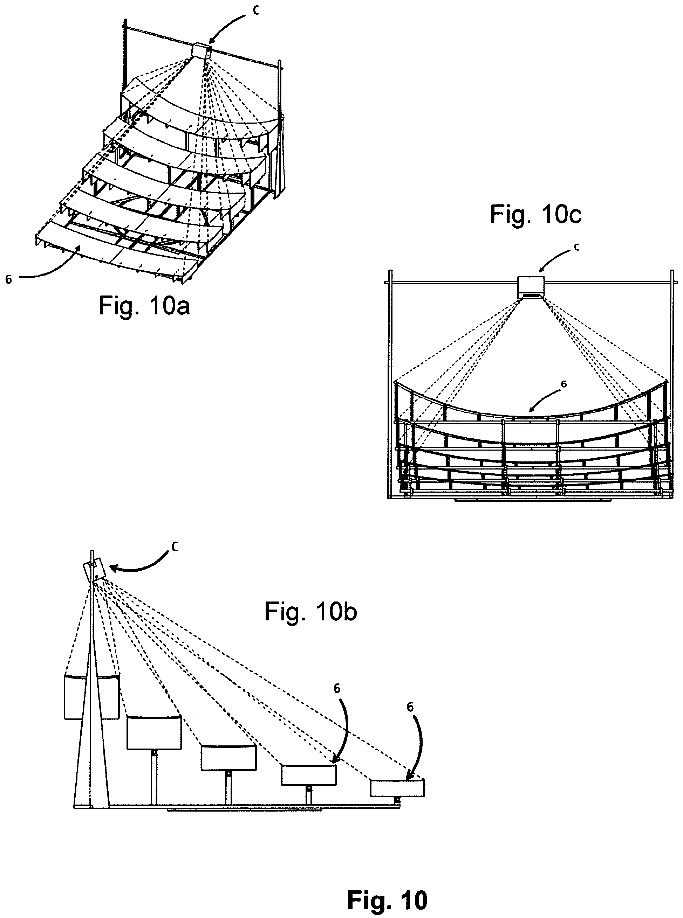

On a représenté sur la **Figure 7** annexée l'agencement actuel. Les miroirs légèrement concaves (6) sont étagés et orientés de manière à focaliser le rayonnement solaire (R) (non représenté car évident) vers la face inférieure (5) photovoltaïque du collecteur (C) ; on minimise ainsi l'emprise au sol tout en focalisant selon le principe des « deux axes » cf. ci-dessus et ci-dessous **figure 10****.**

Le collecteur (C) est du type décrit ci-dessus. On n'a représenté ni l'arrivée et la sortie du fluide caloporteur (ce qui peut cependant être effectué par les supports (40) et (41) ou par des canalisations différentes), ni le câblage permettant de récupérer l'énergie électrique produite par la cellule photovoltaïque (ce câblage peut également être monté sur les support (40) et (41) ou de toute autre manière qui sera évidente à l'homme de métier).

L'invention, au lieu de dissiper cette énergie thermique, la dirige (flèche TH) (**figure 5**) vers la surface inférieure du collecteur thermique (3) : ainsi se réalise la synergie par cet apport thermique très important.

Comme pour le rayonnement thermique (R), la représentation de la flèche (TH) est schématique et il est bien évident que l'énergie thermique (RH) se dissipe de manière uniforme dans tout le volume (11) et vient donc chauffer fortement l'intégralité de la surface inférieure du collecteur thermique (3).

On a représenté un parcours rectiligne pour le fluide caloporteur, mais on installera de préférence des chicanes etc... afin de maximiser l'échange thermique entre la surface inférieure du collecteur thermique (3), portée à très haute température (ordre de grandeur de 200°C), et le fluide caloporteur (porté à 150°C dans ce cas de figure).

A titre d'exemple non limitatif, le capteur solaire du type de la **Figure 6** présente une surface totale de miroirs (6) de seulement 25 m² et la concentration du rayonnement solaire représente un facteur très élevé de l'ordre de 1000 qui est focalisé sur une surface réceptrice (5) de 0,025 m².

On note la très faible et surprenante surface de la surface réceptrice (face inférieure du panneau photovoltaïque exposée au rayonnement solaire R) : 0,025 m². Ceci présente un énorme avantage qui est que, dans un capteur solaire, plus la surface réceptrice est grande, plus les pertes thermiques sont élevées, et plus le rendement baisse. Cependant, dans l'art antérieur il était difficile de s'affranchir de grandes surfaces réceptrices de par la conception rudimentaire des capteurs. Au contraire, le Demandeur a vaincu ce préjugé et a cherché à travailler sur un concept opposé de très faible surface réceptrice générant de très faibles pertes, ce qui sous tend l'invention. Il y est parvenu grâce à la combinaison synergique inventive décrite ci-dessus qui autorise un rendement exceptionnel déjà du seul fait de la conception, avec de plus l'avantage supplémentaire de générer très peu de pertes en raison de sa très faible surface réceptrice.

Un tel capteur comporte naturellement des supports, des éléments motorisés etc... de type connus permettant de suivre la course du soleil, avec notamment un suiveur d'azimut monté sur le collecteur (C) et un élément de mesure d' « angle solaire » placé devant les miroirs ; ceci est de type connu et ne sera pas développé.

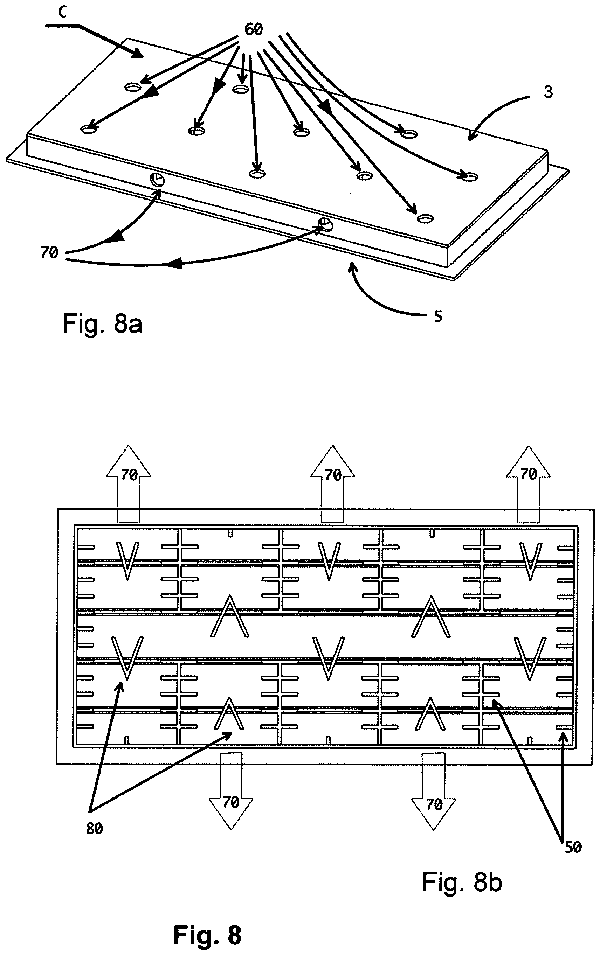

On a représenté sur la **Figure 8****,** qui se compose des Figures 8a et 8b un mode d'alimentation du collecteur thermique (3) en fluide caloporteur « froid » (flèches 60 avec arrivée du fluide par le dessus du collecteur thermique) ainsi que l'évacuation du fluide caloporteur chaud par les côtés (flèches 70) de ce même collecteur thermique.

On rappelle qu'il est évidemment possible d'opter pour d'autres configurations comme par exemple une alimentation et évacuation « linéaires » selon l'axe horizontal du collecteur thermique, cf. **Figure 5****,** ou toute autre option qui sera évidente à tout homme de métier.

Un point important, et ce quelque soit le mode d'alimentation/évacuation du fluide caloporteur c'est-à-dire notamment selon la **Figure 5** ou la **Figure 8** est qu'il est hautement préférable de disposer dans le volume interne du collecteur thermique (3) des dispositifs dont la fonction est de maximiser l'échange thermique entre la paroi inférieure très chaude (portée entre environ 60°C et 800°C selon les régions du monde et autres considérations évidentes) du collecteur thermique (3) et le fluide caloporteur, afin de maximiser le rendement thermique.

On notera que, dans certaines zones géographiques, 60°C représente un très bon résultat, alors que les capteurs de l'art antérieur y sont en pratique inutilisables car absolument non rentables.

Sur la **Figure 8a****,** on a représenté un mode non limitatif comportant des chicanes (50) augmentant l'effet de convection dans le collecteur thermique, et des chevrons (80) servant au guidage du flux de fluide, lequel arrive par le dessus (chemin non représenté) et sort latéralement par les flèches 70.

D'autres dispositions apparaîtront clairement à l'homme de métier comme une forme hélicoïdale chargée de mettre en rotation le fluide, ceci étant notamment adapté à l'alimentation « horizontale » de la figure 5, ou bien d'autres solutions à chicanes ou autres obstacles.

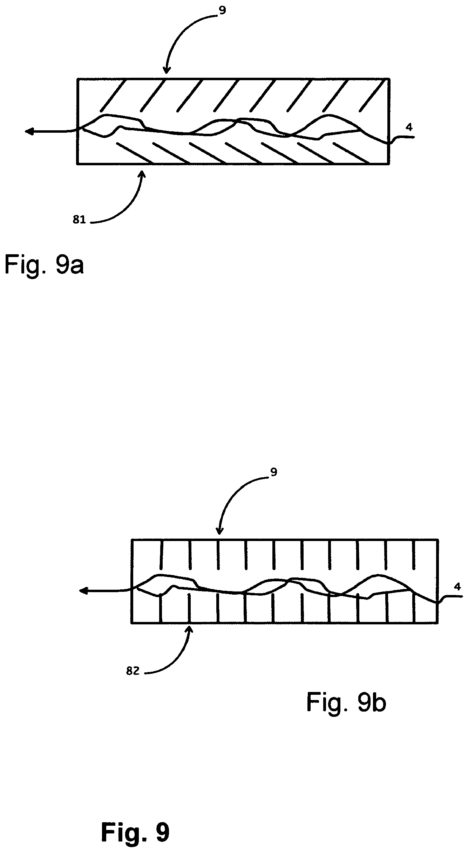

On a représenté quelques options sur la **Figure 9** qui se compose des Figures 9a, 9b et 9c des exemples non limitatifs de chicanes (81) et (82) visant à optimiser l'échange thermique.

On a représenté sur la **Figure 10** qui se compose des **Figures 10a, 10b et 10c** le principe de la « concentration 2 axes » du rayonnement solaire.

La Figure 10a représente le schéma général d'installation comparable à celui de la Figure 7 avec un collecteur (C) et des miroirs courbes (6).

La Figure 10b représente la concentration selon l'axe 1.

La Figure 10c représente la concentration selon l'axe 2.

On notera que les miroirs ont toujours une double courbure afin de pouvoir concentrer le rayonnement solaire (R) selon deux axes. Dans le cas de figure, le miroir de projection rectangulaire est courbé dans sa plus petite largeur (ou dimension) comme présenté plus haut mais aussi dans le sens de la longueur avec une flèche respectant elle aussi la limite élastique du verre employé, cf. Figure 4a où cela reste explicite.

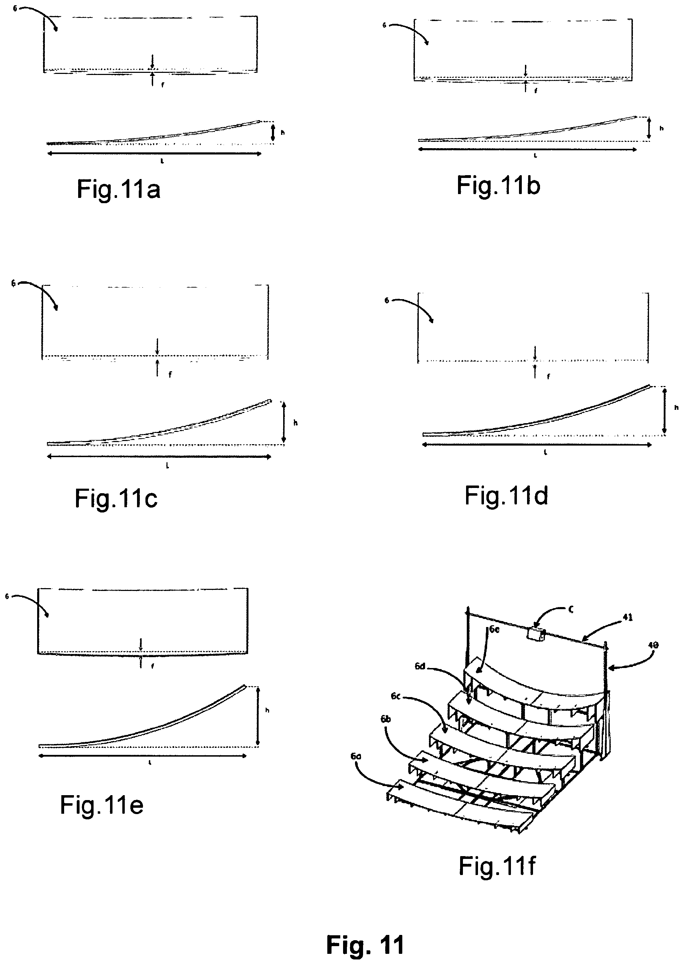

A titre d'exemple non limitatif, un système très performant est constitué de 10 miroirs répartis en cinq formes différentes, ceci étant représenté à titre évidemment non limitatif sur la Figure 11 avec les focales correspondantes. Ceci forme une combinaison de cinq paraboles différentes représentées sur les figures 11a, 11b, 11c, 11d, 11e et 11f qui procure la spécificité précieuse de disposer d'un capteur (miroirs) à multi points focaux, multiplicité réalisée par la double forme concave de chaque demi-miroir.

On notera enfin que l'ensemble du collecteur (C) est entouré d'un isolant thermique de grande épaisseur, de l'ordre de 20 à 30 cm et ce sur TOUTES ses faces y compris la face supérieure pourtant exposée au rayonnement solaire direct, et **SAUF** sur sa face inférieure au contact du substrat (14) (11).

Naturellement, le panneau photovoltaïque (5) ne porte pas de couche isolante (il reçoit l'énergie (R)). cf **Figure 5****, et surtout 12** .

Il peut paraître paradoxal d'isoler la face supérieure du collecteur (C) car on pourrait penser que le rayonnement solaire contribuerait à chauffer le fluide caloporteur « par le dessus ». Or, le rendement du collecteur (C) selon l'invention est d'une telle magnitude qu'il n'en est rien : le NON isolement thermique de la face supérieure générerait en fait plus de pertes thermiques que de chauffage tellement le fluide caloporteur est porté à haute température.

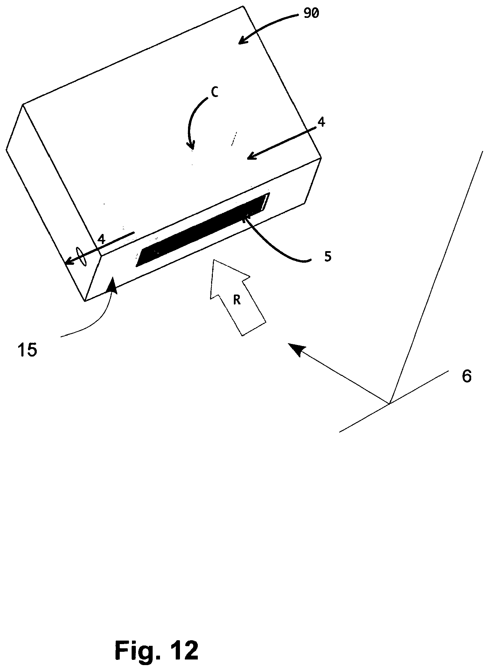

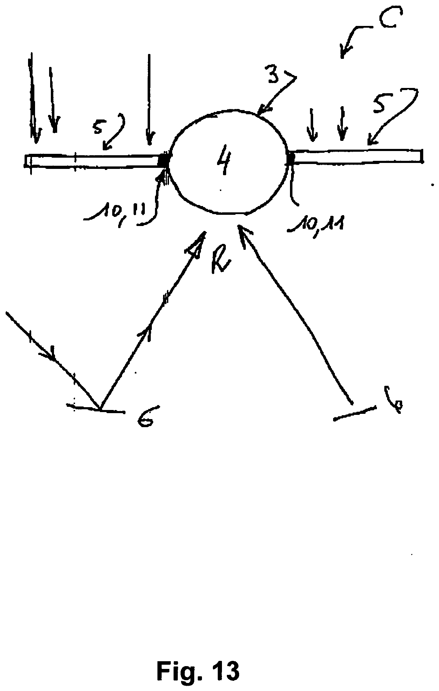

On voit sur la **Figure 12** une représentation très schématique de ce principe : le « collecteur » (C) est entouré d'une grande épaisseur d'isolant thermique (90), polystyrène ou analogue, SAUF sur sa face inférieure (15) ou la partie de celle-ci qui comporte le/les panneaux photovoltaïques (5), face (15) ou partie de cette face (15) qui doit bien entendu être exposée au rayonnement solaire focalisé (R). Tous les autres éléments du collecteur (C) sont « noyés » dans l'isolant.

On voit donc que le principe de l'invention qui est de chauffer le fluide caloporteur intégralement « par le dessous » (Figure 5) et absolument pas « par le dessus » représente une **approche inverse de l'art antérieur** qui est rendue encore plus efficace grâce à la **synergie avec l'échauffement très important des cellules photovoltaïques** sélectionnées, sans parler de la **production connexe d'énergie électrique** par ces cellules.

Les capteurs et collecteurs décrits dans la présente demande pourront être utilisés, de manière non limitative, pour notamment alimenter une unité frigorifique (générateur de frigories), chauffage de locaux, **dont** :
- Production de chauffage,
- Production d'eau chaude sanitaire,
- Production de chauffage piscine,
- Production de climatisation (couple avec groupe climatisation)
- Production d'électricité photovoltaïque,
- Production de froid industriel (couple avec groupe frigorifique)
- Production fluide caloporteur haute température,
- Production de vapeur,
- Eclairage urbain

Et pourront être utilisés , de manière non limitative dans :
- *Immeuble de bureau,*
- *Maison individuelle,*
- *Immeuble d'habitation collectif,*
- *Usine de congélation,*
- *Entrepôt frigorifique,*
- *Usine de désalinisation,*
- *Usine de pompage,*
- *Usine de séchage,*
- *Utilisation en préchauffage de four,*
- *Usine de cuisson,*
- *Complexe sportif,*
- *Eclairage urbain,*
- *Alimentation réseau de chauffage urbain,*
- *Alimentation borne de rechargement véhicule électrique,*
- *Alimentation réseau électrique,*
- *Stockage d'électricité,*
- *Vente d'électricité au réseau,*
- *Alimentation turbine à vapeur,*
- *Alimentation motrice Stirling,*
- *Alimentation bâtiment autonome,*
- *Etc*

## Revendications

1. **Capteur solaire** du type général dénommé à point solaire , employant des miroirs concaves, à concavité orientée pour une focalisation du rayonnement thermique vers un collecteur solaire, qui focalisent le rayonnement solaire vers le collecteur solaire (C) comprenant essentiellement un **collecteur thermique** (3) où circule un fluide caloporteur (4), **caractérisé en ce que** le collecteur thermique (3) est en combinaison synergique avec un **collecteur électrique** (5) constitué par au moins un panneau photovoltaïque dont la chaleur (TH) due à l'exposition solaire directe et à son échauffement intrinsèque est dissipée vers le collecteur thermique, **en ce que** la surface active (5, 15) du collecteur solaire (C) électrique, placée sous le collecteur thermique (3) et exposée au rayonnement solaire réfléchi par les miroirs concaves par le dessous, est située au point focal de la concentration (R) du rayonnement solaire, et **en ce que**
les miroirs sont tous placés d'un même côté par rapport au collecteur solaire (C), les miroirs étant étagés graduellement de manière à ce que le miroir le plus éloigné du collecteur solaire soit le plus bas et le miroir le plus proche du collecteur solaire soit le plus élevé, et les miroirs étant orientables individuellement pour une focalisation sur le collecteur solaire (C) sans effet d'ombrage.

2. Capteur selon la revendication 1, **caractérisé en ce qu'**on emploie, pour chaque miroir, une série de petits miroirs plats, lesdits petits miroirs plats étant arrangés de manière adjacente pour former une forme non plane généralement parabolique orientée vers le collecteur (C).

3. Capteur selon la revendication 1, **caractérisé en ce que** les miroirs solaires (2) (6) sont de type courbés selon un mode concave, dans la limite d'élasticité connue du verre.

4. Capteur selon la revendication 3, **caractérisé en ce que** les miroirs présentent une forme rectangulaire, avec une **largeur** l de 941 mm, une **longueur** L de 2500 mm et une **flèche** f de 15,5 mm.

5. Capteur selon la revendication 3 ou 4, **caractérisé en ce que** la flèche **f** est de l'ordre de 1/30 à 1/150 de la plus petite dimension du miroir, **L** est compris entre 100 et 10000mm, l entre 10 et 2500 mm et **f** entre 0,5 et 100 mm avec une épaisseur **e** de la plaque de verre qui est comprise entre 0,1 et 10 mm, particulièrement 2 mm.

6. Capteur solaire selon l'une des revendications 1 à 5, **caractérisé en ce qu'**il combine un équipement de concentration du type général dit à point solaire qui emploie un nombre adapté de miroirs (2) (6) non plats, légèrement courbés, focalisant le rayonnement solaire (R) vers un tube (7) récupérateur d'énergie thermique formant le collecteur thermique (3)dans lequel circule un fluide caloporteur (4) avec au moins un et de préférence deux panneaux photovoltaïques (5) formant le collecteur électrique disposés horizontalement le long dudit collecteur thermique, lesdits panneaux et ledit tube étant mécaniquement et physiquement liés les uns aux autres notamment par la liaison physique (10) (11) pour permettre la dissipation par contact physique et liaison mécanique de la chaleur (TH) emmagasinée dans les panneaux vers le collecteur thermique (3).

7. Capteur selon l'une quelconque des revendications 1 à 6, **caractérisé en ce que** l'ensemble formé par collecteur thermique (3) et l'au moins un panneau solaire photovoltaïque (5) formant ensemble le collecteur solaire (C), est mobile selon un axe vertical (VP) avec une hauteur moyenne (H) de position au-dessus du miroir supérieur de l'ordre de 2 m, afin d'optimiser la concentration selon la hauteur et la position du soleil.

8. Capteur selon l'une quelconque des revendications 1 à 7, **caractérisé en ce que** le collecteur solaire (C) est mobile sur un support non vertical.

9. Capteur solaire selon l'une quelconque des revendications 1 à 8, **caractérisé en ce que** l'ensemble du capteur solaire (1) est mobile en rotation sur 360° ou environ 300° selon une orientation générale est-ouest afin de suivre l'azimut du soleil, en fonction de la saison et des heures de la journée, et les miroirs sont orientables individuellement par un système à rotule ou analogue.

10. Capteur selon l'une quelconque des revendications 1 à 9, **caractérisé en ce que** le collecteur thermique (3) est en acier inoxydable de qualité 316 L ou encore en cuivre et est un corps creux de section, de préférence un tube allongé de section transversale rectangulaire ou carrée.

11. Capteur selon l'une quelconque des revendications 1 à 10, **caractérisé en ce que** la face inférieure (5) du collecteur solaire c (C) est le collecteur électrique, typiquement la face réceptrice d'un ou des panneau(x) photovoltaïque(s) (5), la face réceptrice étant la face du panneau destinée par le fabricant à recevoir l'énergie solaire (R), et **en ce que** le collecteur solaire (C) se compose de :
- au moins un panneau photovoltaïque, formant le collecteur électrique (5), formant la face inférieure réceptrice du collecteur solaire (C) exposée en totalité ou quasi-totalité au rayonnement (R) réfléchi et focalisé par les miroirs (2, 6) ;
- un ensemble de connexion et de transmission thermique (10) (11) de la chaleur (TH) du/des panneau(x) photovoltaïque(s) (5) vers le collecteur thermique (3), cet ensemble étant lui-même composé de :
- un connecteur électrique (12) pour la cellule photovoltaïque, à forte conductivité électrique autorisant la transmission de l'énergie thermique (TH),
- un substrat non conducteur de l'électricité (13) mais autorisant la transmission de l'énergie thermique (TH),
- une plaque thermique (14) conductrice de l'énergie thermique assurant un contact parfait avec la surface inférieure du collecteur thermique,
- le collecteur thermique (3) dans lequel circule le fluide caloporteur (4).

12. Capteur selon la revendication 11, **caractérisé en ce que** la couche (14) ou plaque thermique n'est présente que si la face inférieure du collecteur thermique ne la forme pas elle-même, et dans ce cas la couche (14) est réduite à une épaisseur appropriée de colle réalisant l'adhérence entre le panneau photovoltaïque et le collecteur thermique.

13. Capteur selon l'une quelconque des revendications 1 à 12 **caractérisé en ce que** les panneaux photovoltaïques sont composés de cellules photovoltaïques du type monocristallin ou polycristallin, de préférence de type multicouches, intrinsèque et par exposition directe au rayonnement solaire (R).

14. Capteur selon la revendication 1, **caractérisé en ce que** les panneaux photovoltaïques sont composés de entre 20 et 300 cellules dites à multicouches.

15. Capteur selon l'une quelconque des revendications 1 à 14, **caractérisé en ce que** l'épaisseur de la cellule photovoltaïque dite à multicouches est inférieure à 20 microns, de préférence à 10 microns.

16. Capteur selon la revendication 1 à 15, **caractérisé en ce que**, pour le/les panneau(x) (5), des cellules photovoltaïques dites multicouches se composent de trois microcouches photovoltaïques (5a, 5b, 5c) superposées.

17. Capteur selon l'une quelconque des revendications 1 à 16, **caractérisé en ce que** des chicanes (81, 82) maximisent par turbulence l'échange thermique entre la surface inférieure du collecteur thermique (3), et le fluide caloporteur (4).

18. Capteur selon l'une quelconque des revendications 1 à 17, **caractérisé en ce qu'**il présente une surface totale de miroirs (2) (6) de 25 m² et la concentration du rayonnement solaire R représente un facteur de 1000 qui est focalisé sur une surface réceptrice (5) de panneau(x) photovoltaïque(s) de 0,025 m².

19. Capteur selon l'une quelconque des revendications 1 à 18, **caractérisé en ce que** l'alimentation du collecteur thermique (3) en fluide caloporteur froid (4) se fait
a) par arrivée du fluide par le dessus (60) du collecteur thermique ainsi que l'évacuation du fluide caloporteur chaud par les côtés (70) de ce même collecteur thermique avec éventuellement des chicanes (50) augmentant l'effet de convection dans le collecteur thermique, et des chevrons (80) servant au guidage du flux de fluide,
b) ou selon une alimentation et évacuation linéaires selon l'axe horizontal du collecteur thermique.

20. Capteur selon l'une quelconque des revendications 1 à 19, **caractérisé en ce que** la concentration du rayonnement solaire s'opère par la concentration 2 axes en employant des miroirs qui ont toujours une double courbure afin de pouvoir concentrer le rayonnement solaire (R) selon deux axes, par exemple des miroirs de projection rectangulaires courbés dans la plus petite largeur (ou dimension) mais aussi dans le sens de la longueur avec une flèche f respectant elle aussi la limite élastique du verre employé.

21. Capteur selon l'une quelconque des revendications 1 à 20, **caractérisé en ce que** l'ensemble du collecteur (C) est entouré d'un isolant thermique d' épaisseur comprise entre 20 à 30 cm et ce sur TOUTES ses faces y compris la face supérieure pourtant exposée au rayonnement solaire direct, et SAUF sur sa face inférieure (15) ou la partie de celle-ci au contact du panneau (5).

22. Applications des capteurs selon l'une quelconque des revendications 1 à 21, dans une des applications suivantes:
production de chauffage, production d'eau chaude sanitaire, production de chauffage piscine, production de climatisation, production d'électricité photovoltaïque, production de froid industriel , production fluide caloporteur haute température, production de vapeur, éclairage urbain.

## Patentansprüche

1. Sonnenkollektor vom Typ, welcher allgemein als "Sonnenpunkt" bezeichnet wird, wobei konkave Spiegel mit einer Konkavität eingesetzt werden, welche für eine Fokussierung von Wärmestrahlung zu einem Sonnenkollektor orientiert ist, welche die Sonnenstrahlung in Richtung des Sonnenkollektors (C) fokussieren, welcher im Wesentlichen einen Wärmekollektor (3) umfasst, in welchem ein Wärmeträgermittel zirkuliert, **dadurch gekennzeichnet, dass** der Wärmekollektor (3) in synergetischer Kombination mit einem elektrischen Kollektor (5) steht, welcher durch wenigstens eine Fotovoltaik-Platte gebildet ist, deren Wärme (TH) aufgrund von direkter Sonneneinstrahlung und deren intrinsische Erwärmung zu dem Wärmekollektor abgeführt wird, und dass die aktive Fläche (5, 15) des elektrischen Sonnenkollektors (C), welche unter dem Wärmekollektor (3) platziert und der von den darunter liegenden konkaven Spiegeln reflektierten Sonnenstrahlung ausgesetzt ist, im Brennpunkt der Konzentration (R) der Sonnenstrahlung angeordnet ist, und dass die Spiegel sämtlich auf einer gleichen Seite bezüglich des Sonnenkollektors (C) platziert sind, wobei die Spiegel graduell derart abgestuft sind, dass der am weitesten von dem Sonnenkollektor entfernte Spiegel der niedrigste ist und der dem Sonnenkollektor nächste Spiegel der höchste ist, und wobei die Spiegel individuell für eine Fokussierung auf den Sonnenkollektor (C) ohne Schattenwirkung orientierbar sind.

2. Kollektor nach Anspruch 1, **dadurch gekennzeichnet, dass** für jeden Spiegel eine Reihe von kleinen ebenen Spiegeln eingesetzt wird, wobei die kleinen ebenen Spiegel in angrenzender Weise derart angeordnet sind, dass eine nicht ebene, im Wesentlichen parabolische Form gebildet wird, welche zu dem Kollektor (C) orientiert ist.

3. Kollektor nach Anspruch 1, **dadurch gekennzeichnet, dass** die Sonnenspiegel (2) (6) vom gekrümmten Typ gemäß einem konkaven Modus an der bekannten Elastizitätsgrenze des Glases sind.

4. Kollektor nach Anspruch 3, **dadurch gekennzeichnet, dass** die Spiegel eine rechteckige Form mit einer Breite I von 941 mm, einer Länge L von 2500 mm und einer Durchbiegung f von 15,5 mm aufweisen.

5. Kollektor nach Anspruch 3 oder 4, **dadurch gekennzeichnet, dass** die Durchbiegung f in der Größenordnung von 1/30 bis 1/150 der kleinsten Abmessung des Spiegels ist, L zwischen 100 und 10000 mm, l zwischen 10 und 2500 mm und f zwischen 0,5 und 100 mm beträgt, mit einer Dicke e der Glasplatte, welche zwischen 0,1 und 10 mm beträgt, insbesondere 2 mm.

6. Sonnenkollektor nach einem der Ansprüche 1 bis 5, **dadurch gekennzeichnet, dass** er eine Ausrüstung zum Konzentrieren vom allgemein als Sonnenpunkt bezeichneten Typ, welche eine geeignete Anzahl von nicht ebenen, leicht gekrümmten Spiegeln (2) (6) verwendet, welche die Sonnenstrahlung (R) in Richtung eines Rekuperatorrohrs (7) für thermische Energie fokussiert, welches den Wärmekollektor (3) bildet, in welchem ein Wärmeträgermittel (4) zirkuliert, mit wenigstens einem und vorzugsweise zwei Fotovoltaik-Platten (5) kombiniert, welche den elektrischen Kollektor bilden, horizontal entlang des Wärmekollektors angeordnet, wobei die Platten und das Rohr mechanisch und physisch miteinander verbunden sind, insbesondere durch physische Verbindung (10) (11), um das Abführen der in den Platten gespeicherten Wärme (TH) zu dem Wärmekollektor (3) durch physischen Kontakt und mechanische Verbindung zu ermöglichen.

7. Kollektor nach einem der Ansprüche 1 bis 6, **dadurch gekennzeichnet, dass** die durch den Wärmekollektor (3) und die wenigstens eine Solar-Fotovoltaik-Platte (5) gebildete Baugruppe, welche gemeinsam den Sonnenkollektor (C) bilden, entlang einer vertikalen Achse (VP) bewegbar ist, mit einer mittleren Höhe (H) der Position oberhalb des oberen Spiegels in der Größenordnung von 2 m, um die Konzentration gemäß der Höhe und der Position der Sonne zu optimieren.

8. Kollektor nach einem der Ansprüche 1 bis 7, **dadurch gekennzeichnet, dass** der Sonnenkollektor (C) an einem nicht vertikalen Träger beweglich ist.

9. Sonnenkollektor nach einem der Ansprüche 1 bis 8, **dadurch gekennzeichnet, dass** die Baugruppe des Sonnenkollektors (1) in Rotation um 360° oder etwa 300° gemäß einer im Wesentlichen Ost-West-Richtung beweglich ist, um dem Azimut der Sonne als Funktion der Jahreszeit und den Stunden des Tages zu folgen, und wobei die Spiegel durch ein Kugelgelenk oder ähnliches individuell orientierbar sind.

10. Sonnenkollektor nach einem der Ansprüche 1 bis 9, **dadurch gekennzeichnet, dass** der Wärmekollektor (3) aus rostfreiem Stahl der Qualität 316 L oder auch aus Kupfer besteht und ein Körper mit hohlem Querschnitt ist, vorzugsweise ein längliches Rohr mit rechteckigem oder quadratischem transversalem Querschnitt.

11. Kollektor nach einem der Ansprüche 1 bis 10, **dadurch gekennzeichnet, dass** die untere Fläche (5) des Sonnenkollektors (C) der elektrische Kollektor ist, typischerweise die Aufnahmefläche von der einen oder den mehreren Fotovoltaik-Platte(n) (5), wobei die Aufnahmefläche die Fläche der Platte ist, welche vom Hersteller dazu vorgesehen ist, Sonnenenergie (R) zu empfangen, und dass der Sonnenkollektor (C) aufgebaut ist aus:
- wenigstens einer Fotovoltaik-Platte, welche den elektrischen Kollektor (5) bildet, wobei die untere Aufnahmefläche des Sonnenkollektors (C) gebildet wird, welche in ihrer Gesamtheit oder quasi-Gesamtheit der von den Spiegeln (2, 6) reflektierten und fokussierten Strahlung (R) ausgesetzt ist;
- einer Baugruppe zur Verbindung und der thermischen Übertragung (10) (11) der Wärme (TH) des/der Fotovoltaik-Platte(n) (5) zu dem Wärmekollektor (3), wobei diese Baugruppe wiederum aufgebaut ist aus:
- einem elektrischen Verbindungselement (12) für die Fotovoltaik-Zelle mit hoher elektrischer Leitfähigkeit, wodurch die Übertragung der Wärmeenergie (TH) erlaubt wird,
- einem elektrisch nicht leitfähigen Substrat (13), welches jedoch die Übertragung der Wärmeenergie (TH) erlaubt,
- einer leitfähige Wärme-Platte (14) für die Wärmeenergie, welche einen perfekten Kontakt mit der unteren Fläche des Wärmekollektors sicherstellt,
- dem Wärmekollektor (3), in welchem das Wärmeträgermittel (4) zirkuliert.

12. Kollektor nach Anspruch 11, **dadurch gekennzeichnet, dass** die Wärme-Schicht (14) oder -Platte nur vorliegt, wenn die untere Fläche des Wärmekollektors sie nicht selbst bildet, und wobei in diesem Fall die Schicht (14) auf eine angemessene Dicke zum Verkleben reduziert ist, welche die Haftung zwischen der Fotovoltaik-Platte und dem Wärmekollektor ausbildet.

13. Kollektor nach einem der Ansprüche 1 bis 12, **dadurch gekennzeichnet, dass** die Fotovoltaik-Platten aus Fotovoltaik-Zellen vom monokristallinen oder polykristallinen Typ aufgebaut sind, vorzugsweise vom intrinsischen Mehrschicht-Typ und durch direkte Exposition gegenüber der Sonnenstrahlung (R).

14. Kollektor nach Anspruch 1, **dadurch gekennzeichnet, dass** die Fotovoltaik-Platten aus zwischen 20 und 300 sogenannten Mehrschicht-Zellen aufgebaut sind.

15. Kollektor nach einem der Ansprüche 1 bis 14, **dadurch gekennzeichnet, dass** die Dicke der sogenannten Mehrschicht-Fotovoltaik-Zelle kleiner als 20 Mikron ist, vorzugsweise kleiner als 10 Mikron.

16. Kollektor nach Anspruch 1 bis 15, **dadurch gekennzeichnet, dass** sich für die Platte(n) (5) die sogenannten Mehrschicht-Fotovoltaik-Zellen aus drei überlagerten Fotovoltaik-Mikroschichten (5a, 5b, 5c) aufbauen.

17. Kollektor nach einem der Ansprüche 1 bis 16, **dadurch gekennzeichnet, dass** Blenden (81, 82) durch Turbulenzen den Wärmeaustausch zwischen der unteren Fläche des Wärmekollektors (3), welche bei einer Temperatur in der Größenordnung von gleich 200°C gehalten wird, und dem Wärmeträgermittel (4) maximieren.

18. Kollektor nach einem der Ansprüche 1 bis 17, **dadurch gekennzeichnet, dass** er eine Gesamtfläche von Spiegeln (2) (6) von 25 m² aufweist und die Konzentration der Sonnenstrahlung R einen Faktor von 1000 darstellt, welcher auf eine Aufnahmefläche (5) der Fotovoltaik-Platte(n) von 0,025 m² fokussiert wird.

19. Kollektor nach einem der Ansprüche 1 bis 18, **dadurch gekennzeichnet, dass** die Versorgung des Wärmekollektors (3) mit kaltem Wärmeträgermittel (4) durchgeführt wird durch:
a) Ankunft des Mittels von der Oberseite (60) des Wärmekollektors, sowie Ableitung des heißen Wärmeträgermittels über die Seiten (70) des selben Wärmekollektors gegebenenfalls mit Blenden (50), welche die Konvektionswirkung in dem Wärmekollektor erhöhen, und Sparren (80), welche zur Führung des Stroms des Mittels dienen,
b) oder gemäß einer linearen Versorgung und Ableitung entlang der horizontalen Achse des Wärmekollektors.

20. Kollektor nach einem der Ansprüche 1 bis 19, **dadurch gekennzeichnet, dass** die Konzentration der Sonnenstrahlung durch die 2-Achsen-Konzentration durch Verwendung von Spiegeln geschieht, welche stets eine doppelte Krümmung aufweisen, um die Sonnenstrahlung (R) entlang zweier Achsen konzentrieren zu können, beispielsweise rechteckige Projektionsspiegel, welche in der kleinen Länge (oder Abmessung) gekrümmt sind, jedoch auch in dem Sinn der Länge mit einer Durchbiegung f, welche selbst ebenfalls die Elastizitätsgrenze des verwendeten Glases beachtet.

21. Kollektor nach einem der Ansprüche 1 bis 20, **dadurch gekennzeichnet, dass** die Baugruppe des Kollektors (C) von einem thermischen Isolator von einer Dicke umgeben ist, welche zwischen 20 und 30 cm beträgt, und zwar an allen seinen Flächen einschließlich der oberen Fläche, welche trotzdem der direkten Sonnenstrahlung ausgesetzt ist, und außer seiner unteren Fläche (15) oder dem Abschnitt davon in Kontakt mit der Platte (5).

22. Anwendung von Kollektoren nach einem der Ansprüche 1 bis 21, insbesondere zur Versorgung einer Kälteeinheit, Raumheizung, darunter:
- Wärmeerzeugung,
- Erzeugung von sanitärem Warmwasser,
- Erzeugung von Badeanlagenbeheizung,
- Erzeugung von Klimatisierung,
- Erzeugung von Fotovoltaik-Elektrizität,
- Erzeugung von industrieller Kälte,
- Erzeugung von Wärmeträgermittel mit hoher Temperatur,
- Dampferzeugung,
- städtische Beleuchtung.

## Claims

1. **Solar collector** of the general type called a solar point focus collector making use of concave mirrors with oriented concavity for focussing of thermal radiation to a solar concentrator, that focus solar radiation to the solar concentrator (C) comprising essential a **thermal collector** (3) in which a heat transporting fluid (4) circulates, **characterised in that** the thermal collector (3) is in synergic combination with an **electrical collector** (5) composed of at least one photovoltaic panel of which the heat (TH) due to direct solar exposure and its intrinsic heating is dissipated to the thermal collector, **in that** the active surface (5, 15) of the electrical solar concentrator (C) placed under the thermal collector (3) and exposed to solar radiation reflected by concave mirrors from underneath, is located at the focal point of the concentration (R) of solar radiation and **in that**
all the mirrors are placed on the same side as the solar concentrator (C), the mirrors being gradually staged such that the mirror furthest from the solar concentrator is lowest and the mirror closest to the solar concentrator is highest, and the mirrors being individually oriented to focus on the solar concentrator (C) without any shadow effect.

2. Collector according to claim 1, **characterised in that** for each mirror, a series of small flat mirrors is used, said small flat mirrors being arranged adjacent to each other to form a non-plane generally parabolic shape oriented towards the concentrator (C).

3. Collector according to claim 1, **characterised in that** the solar mirrors (2) (6) are curved in a concave fashion, within the known yield strength of glass.

4. Collector according to claim 3, **characterised in that** the mirrors are rectangular in shape, with a **width** l of 941 mm, a **length** L of 2500 mm and a **deflection** f of 15.5 mm.

5. Collector according to claim 3 or 4, **characterised in that** the deflection **f** is of the order of 1/30 to 1/150 of the smallest dimension of the mirror, **L** is between 100 and 10000 mm, **I** is between 10 and 2500 mm and **f** is between 0.5 and 100 mm with a thickness **e** of the glass plate that is between 0.1 and 10 mm, particularly 2 mm.

6. Solar collector according to one of claims 1 to 5, **characterised in that** it combines concentration equipment of the general "point focus" type that uses an appropriate number of non-flat, slightly curved mirrors (2) (6), focussing solar radiation (R) to a thermal energy recovery tube (7) forming the thermal collector (3) in which a heat transporting fluid (4) circulates with at least one and preferably two photovoltaic panels (5) forming the electrical collector arranged horizontally along said thermal collector, said panels and said tube being mechanically and physically connected to each other particularly by the physical connection (10) (11) to enable dissipation of heat (TH) stored in the panels to the thermal collector (3), through physical contact and the mechanical connection.

7. Collector according to any one of claims 1 to 6, **characterised in that** the assembly formed by the thermal collector (3) and the at least one photovoltaic solar panel (5) together forming the solar concentrator (C), is free to move along a vertical axis (VP) to a position at a height (H) above the upper mirror equal to the order of 2 m, so as to optimise the concentration depending on the height and position of the sun.

8. Collector according to any one of claims 1 to 7, **characterised in that** the solar concentrator (C) is free to move on a non-vertical support.

9. Solar collector according to any one of claims 1 to 8, **characterised in that** the solar collector assembly (1) is free to rotate around 360° or about 300° along a general east-west orientation so as to follow the azimuth of the sun depending on the season and the time of the day, and the mirrors can be oriented individually by a ball joint or similar system.

10. Collector according to any one of claims 1 to 9, **characterised in that** the thermal collector (3) is made of 316 L grade stainless steel or copper and is a hollow sectional body, preferably an elongated tube with a rectangular or square cross-section.

11. Collector according to any one of claims 1 to 10, **characterised in that** the lower face (5) of the solar concentrator c (C) is the electrical collector, typically the receiving face of one or more photovoltaic panels (5), the receiving face being the face of the panel that the manufacturer has designed to receive solar energy (R) and **in that** the solar concentrator (C) is composed of:
- at least one photovoltaic panel forming the electrical collector (5), forming the lower receiving face of the solar concentrator (C) exposed entirely or almost entirely to radiation (R) reflected and focussed by the mirrors (2, 6);
- a connection and thermal transmission assembly (10) (11) for heat (TH) from the photovoltaic panel(s) (5) to the thermal collector (3), this assembly itself being composed of:
- an electrical connector (12) for the photovoltaic cell, with high electrical conductivity enabling the transmission of thermal energy (TH),
- a substrate that does not conduct electricity (13) but that enables the transmission of thermal energy (TH),
- a thermal plate (14) conducting thermal energy providing perfect contact with the lower surface of the thermal collector,
- the thermal collector (3) in which the heat transporting fluid (4) circulates.

12. Collector according to claim 11, **characterised in that** the layer (14) or thermal plate is only present if the lower face of the thermal collector does not form it itself, and in this case the thickness of the layer (14) is reduced to an appropriate glue thickness forming the bond between the photovoltaic panel and the thermal collector.

13. Collector according to any one of claims 1 to 12, **characterised in that** the photovoltaic panels are composed of photovoltaic cells of the monocrystalline or polycrystalline type, preferably of the multi-layer type, intrinsic and by direct exposure to solar radiation (R).

14. Collector according to claim 1, **characterised in that** the photovoltaic panels are composed of between 20 and 300 multilayer cells.

15. Collector according to any one of claims 1 to 14, **characterised in that** the thickness of the so-called multi-layer photovoltaic cell is less than 20 microns, and preferably 10 microns.

16. Collector according to any one of claims 1 to 15, **characterised in that**, for the panel(s) (5), photovoltaic cells called multi-layer cells are composed of three superposed photovoltaic micro-layers (5a, 5b, 5c).

17. Collector according to any one of claims 1 to 16, **characterised in that** baffles (81, 82) create turbulence and thereby maximise heat exchange between the lower surface of the thermal collector (3) and the heat transporting fluid (4).

18. Collector according to any one of claims 1 to 17, **characterised in that** it has a total surface area of mirrors (2) (6) equal to 25 m² and the concentration of solar radiation R represents a factor of 1000 that is focussed on a receiving surface (5) of photovoltaic panels equal to 0.025 m².

19. Collector according to any one of claims 1 to 18, **characterised in that** the supply of cold heat transporting fluid (4) to the thermal collector (3) is made
a) by the arrival of fluid from above (60) the thermal collector and evacuation of the hot heat transporting fluid through the sides (70) of this same thermal collector possibly with baffles (50) to increase the effect of convention in the thermal collector, and herringbones (80) to guide the fluid flow,
b) or with a linear supply and evacuation along the horizontal axis of the thermal collector.

20. Collector according to any one of claims 1 to 19, **characterised in that** solar radiation is concentrated by concentration along 2 axes making use of mirrors that always have double curvature so that the solar radiation (R) can be concentrated on two axes, for example mirrors with rectangular projection curved along the smallest width (or dimension) but also along the direction of the length with a deflection f also respecting the yield strength of the glass used.

21. Collector according to any one of claims 1 to 20, **characterised in that** the concentrator assembly (C) is surrounded by a thermal insulator with a thickness of between 20 to 30 cm on ALL its faces, including the top face although it is exposed to direct solar radiation, and EXCEPT on its bottom face (15) or the part in contact with the panel (5).

22. Applications of collectors according to any one of claims 1 to 21, in one of the following applications: production of heating, production of domestic hot water, production of swimming pool heating, production of air conditioning, production of photovoltaic electricity, production of industrial cooling, production of high temperature heat transporting fluid, production of steam, urban lighting.
